# DEMANDE DE BREVET EUROPEEN

(11) **EP 3 385 607 A1**
(43) Date de publication de la demande: **10.10.2018**
(21) Numéro de dépôt: 18165817.0
(22) Date de dépôt: 05.04.2018
(51) Int. Cl.: F21S 41/16, F21S 41/19, F21S 45/47, F21S 41/147, F21S 41/14, F21V 19/00, F21V 19/02, H01L 23/04, H01L 23/32, H01S 5/022, H01S 5/024, G02B 7/00, F21Y 115/30, F21V 23/00

(54) **MODULE LUMINEUX POUR VÉHICULE AUTOMOBILE COMPORTANT UNE SOURCE LUMINEUSE À SEMI-CONDUCTEUR**

(30) Priorité: 07.04.2017 FR 1753057
(71) Demandeur: Valeo Vision, 93012 Bobigny Cedex (FR)
(72) Inventeur: BERREZAI, François, 93012 BOBIGNY Cedex (FR); DELANDE, Benoit, 93012 BOBIGNY Cedex (FR)
(74) Mandataire: Valeo Vision

(57) **Abrégé**

L'invention propose un module lumineux (10) comprenant une source lumineuse (14) à semi-conducteur, un réflecteur optique (16) qui est positionné par rapport à la source lumineuse (14), et une surface de référence (12, 24), appartenant à un radiateur de dissipation thermique, sur laquelle sont fixés la source lumineuse (14) et le réflecteur optique (16), caractérisé en ce que la source lumineuse (14) est portée par une monture (26) qui est fixée sur la surface de référence (12, 24) .

Le module lumineux (10) comporte des moyens de réglage de la position de la monture (26) par rapport à la surface de référence (12, 24) et des moyens (50) de fixation de la monture (26) en position réglée sur la surface de référence (12, 24) .

## Description

### DOMAINE TECHNIQUE DE L'INVENTION

L'invention concerne un module lumineux utilisé dans le domaine de l'éclairage et/ou de la signalisation lumineuse, notamment pour un véhicule automobile.

L'invention concerne plus particulièrement un module lumineux comportant au moins une source lumineuse à semi-conducteur qui est associée à un composant optique qui est positionné avec précision par rapport à la source lumineuse, notamment pour recevoir un rayonnement de la au moins une source lumineuse.

### ARRIERE PLAN TECHNIQUE DE L'INVENTION

L'invention concerne plus particulièrement un module lumineux du type mentionné ci-dessus dans lequel la source lumineuse et le composant optique - tel que par exemple un réflecteur optique, un collimateur optique ou une lentille optique - sont positionnés indirectement l'un par rapport à l'autre en étant chacun positionné et fixé avec précision sur une surface de référence commune appartenant par exemple à un radiateur appartenant au module lumineux.

Un tel positionnement précis est particulièrement important dans le cas d'une ou plusieurs sources lumineuses à semi-conducteur(s), et tout particulièrement dans le cas d'une source lumineuse dite source laser.

La source lumineuse doit être position avec des tolérances dimensionnelles réduites selon les trois axes, et notamment inférieures à 1 millimètre, voire à 0,5 mm notamment dans le cas d'une source lumineuse dont le cône lumineux d'émission du rayonnement est très réduit.

La manipulation, le positionnement et la fixation d'une source laser sont rendus particulièrement complexes de par la conception et la conformation de la source lumineuse, et notamment de la relative fragilité de ses bornes de raccordement.

L'invention vis à proposer une solution permettant un réglage précis de la position relative de la source lumineuse à semi-conducteur par rapport au composant optique associé et pouvant notamment être mise en oeuvre dans le cadre d'une fabrication en grande série de modules lumineux.

### BREF RESUME DE L'INVENTION

L'invention propose un module lumineux comprenant :
- au moins une source lumineuse à semi-conducteur ;
- un composant optique qui est positionné par rapport à la source lumineuse ;
- et une surface de référence sur laquelle sont fixés la au moins une source lumineuse et le composant optique,
caractérisé en ce que la au moins une source lumineuse est portée par une monture qui est fixée sur la surface de référence.

Selon d'autres caractéristiques du module lumineux :
- il comporte des moyens de réglage de la position de la monture par rapport à la surface de référence et des moyens de fixation de la monture en position réglée sur la surface de référence ;
- la monture comporte au moins un trou de fixation pour le passage d'un élément de fixation de la monture sur la surface de référence ;
- l'élément de fixation comporte une tige filetée qui s'étend axialement et avec jeu radial à travers le trou de fixation ;
- la source lumineuse comporte un boîtier qui est reçu et positionné dans un logement complémentaire de la monture ;
- la monture comporte deux trous de fixation, et le logement est agencé entre les deux trous de fixation ;
- la monture comporte un corps central dans lequel est agencé le logement, et deux ailes latérales opposées dont chacune s'étend à partir de ce corps et chacune comporte un trou de fixation ;
- le boîtier est monté serré, notamment radialement sans jeu, par introduction axiale dans le logement de la monture ;
- le boîtier est monté dans son logement par introduction selon un axe parallèle à l'axe de la tige filetée ;
- la monture comporte des moyens de préhension par un organe de manipulation permettant de positionner la monture par rapport à la surface de référence ;
- la source lumineuse comporte des bornes de raccordement qui sont décalées radialement par rapport à un axe central de son boîtier, et la monture comporte des moyens de détrompage qui coopèrent avec des moyens complémentaires de la surface de référence pour déterminer une orientation préférentielle de positionnement de la monture ;
- la source lumineuse est une source laser, et le module lumineux comporte un écran de diffusion qui est interposé verticalement entre la monture et la surface de référence ;
- la source lumineuse à semi-conducteur appartient à un groupe comportant notamment une source laser, au moins une diode laser, au moins une diode électroluminescente ;
- le composant optique appartient à un groupe comportant notamment un réflecteur, un collimateur, une lentille ;
- la surface de référence appartient à un radiateur ou un dissipateur thermique.
- la source lumineuse est positionnée directement par rapport à la monture et indirectement par rapport au composant optique qui est positionné par rapport à la surface de référence commune à la monture et au composant optique.

### BREVE DESCRIPTION DES FIGURES

D'autres caractéristiques et avantages de l'invention apparaîtront au cours de la lecture de la description détaillée qui va suivre pour la compréhension de laquelle on se reportera aux dessins annexés dans lesquels :
- la figure 1 est une vue en perspective d'un radiateur de dissipation thermique appartenant à un exemple de réalisation d'un module lumineux dont la face supérieure constitue la surface de référence au sens de l'invention ;
- la figure 2 est une vue en perspective illustrant une source lumineuse laser appartenant au module lumineux en association avec une monture selon l'invention pour le positionnement et la fixation de la source lumineuse laser sur le radiateur de la figure 1 ;
- la figure 3 est une vue en perspective qui illustre le sous-ensemble constitué par la source lumineuse laser et sa monture de positionnement, avant le positionnement et la fixation de ce sous-ensemble sur le radiateur de la figure 1 ;
- la figure 4 est une vue en perspective qui illustre la monture et sa source laser en position réglée sur le radiateur et avant sa fixation sur le radiateur au moyen de vis de fixation ;
- la figure 5 est une vue en perspective qui illustre le radiateur avec la monture en position réglée et fixée, en association avec un composant optique constitué ici par un réflecteur optique ;
- la figure 6 est une vue en perspective qui illustre le mode de réalisation d'un module lumineux selon l'invention après le positionnement et la fixation du réflecteur optique sur le radiateur ;
- la figure 7 est une vue en coupe du module lumineux par un plan vertical et transversal passant par les axes des vis de fixation de la monture sur le radiateur ;

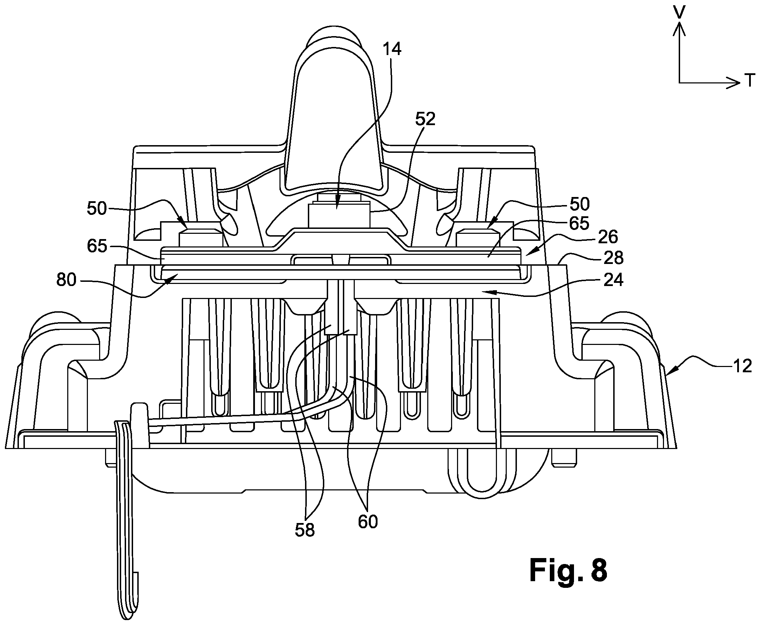

- la figure 8 est une vue axiale en bout du module lumineux de la figure 7 ;
- les figures 9 et 10 sont deux vues en perspective, selon des angles différents de représentation, qui illustrent le sous-ensemble constitué par la monture équipée de sa source lumineuse laser ;
- la figure 11 est une vue longitudinale de face de la monture équipée de sa source lumineuse laser ;
- la figure 12 est une vue en perspective de dessous de la monture ;
- la figure 13 est une vue de dessous du sous-ensemble représenté à la figure 11 ; et
- la figure 14 est une vue en perspective qui illustre l'écran de diffusion en position sur le radiateur avant la mise en place et la fixation de la monture.

### DESCRIPTION DETAILLEE DES FIGURES

Dans la suite de la description, des éléments présentant une structure identique ou des fonctions analogues seront désignés par des mêmes références.

Dans la suite de la description, on adoptera de manière non limitative des orientations longitudinale, verticale et transversale indiquées par le trièdre "L,V,T" des figures. On définit aussi un plan horizontal qui s'étend longitudinalement et transversalement.

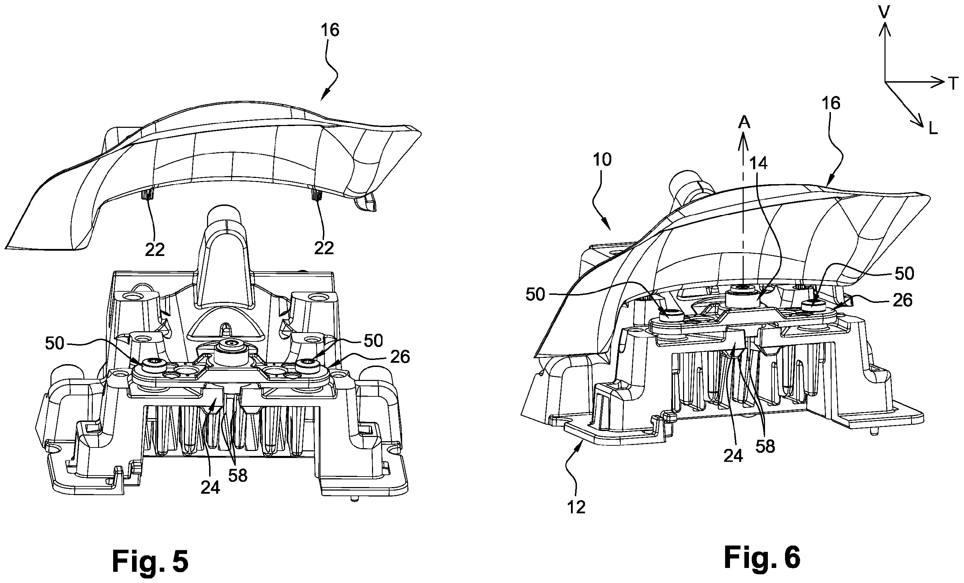

On a représenté à la figure 6 certains éléments et composants appartenant à un module lumineux module d'éclairage 10 qui comporte notamment un radiateur 12, une source lumineuse laser 14 et un réflecteur optique 16.

La source lumineuse à semi-conducteur de type laser 14 est notamment apte à émettre un rayonnement lumineux selon un axe d'émission principal A.

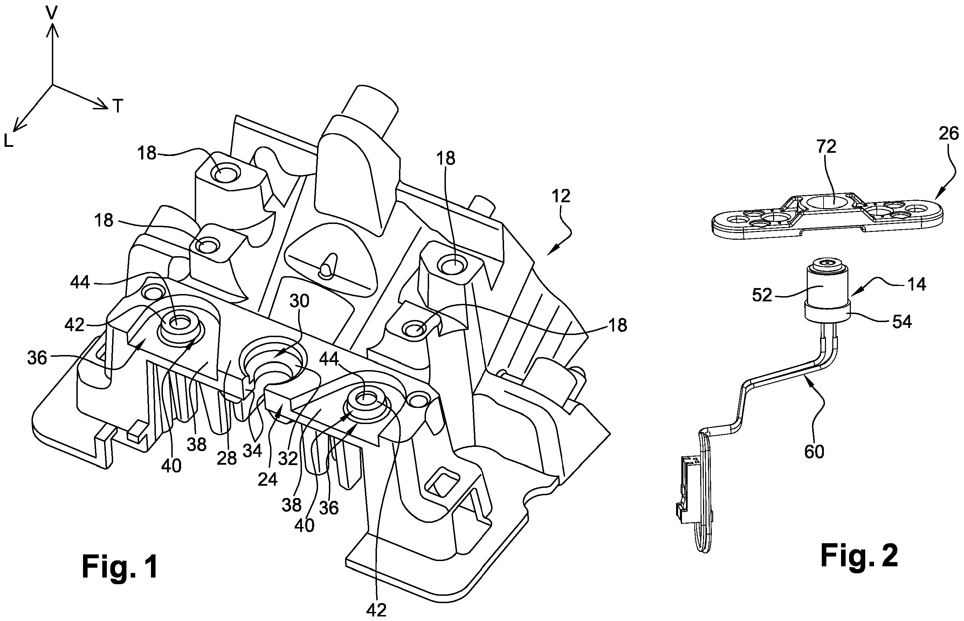

Le radiateur 12, illustré à la figure 1, est une pièce réalisée par moulage de forme complexe qui, outre sa fonction de dissipateur thermique, fait ici fonction de support pour le positionnement relatif et la fixation de la source lumineuse 14 et le réflecteur optique 16.

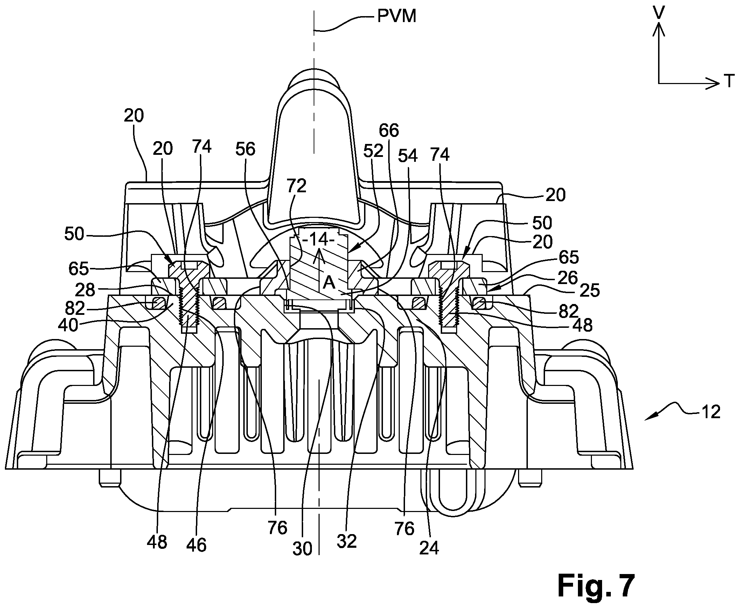

Dans le mode de réalisation illustrée aux figures, le radiateur 12 présent une symétrie générale de conception par rapport à un plan vertical et longitudinal médian PVM indiqué à la figure 7.

Le radiateur 12 est délimité par une enveloppe ou surface extérieure par rapport à laquelle la source lumineuse 14 et le collecteur 16 sont positionnés avec précision, notamment afin de déterminer une position relatif précise d'un composant par rapport à l'autre.

Ainsi, à sa parti arrière, le radiateur 12 comporte, pour le positionnement et la fixation du collecteur optique 16, quatre trous 18 de positionnement et de fixation dont chacun est associé à une portion plane 20 de la surface extérieure du radiateur 12. Chacun des trous 18 est apte à recevoir des éléments complémentaires 20 du collecteur optique 16.

À sa partie longitudinale avant, le radiateur 12 comporte une portion 24 formant platine de fixation pour la source lumineuse laser 14 par l'intermédiaire d'une monture 26 selon l'invention.

La platine 24 est délimitée par une face supérieure plane, ici horizontale, 28 de contour globalement rectangulaire dont la longueur s'étend selon l'axe transversal T.

La platine 24 comporte en son centre un logement cylindrique étagé 30, ici de section circulaire dont l'axe d'orientation globalement verticale.

Le logement 30 est délimité verticalement vers le bas par un fonds annulaire 32.

Le logement étagé 30 est ouvert radialement, ici selon la direction longitudinale vers l'avant, sous la forme d'un passage vertical 34 délimité par 2 facettes verticales et longitudinales opposées.

Symétriquement de part et d'autres du logement étagé 30, la platine 24 comporte deux évidements 36 en forme de lamage dont chacun est délimité par un fond horizontal 38.

Sensiblement au centre de chaque évidement 36, la platine 24 comporte un plot de fixation 40 de forme générale tronc conique qui est délimité par une face supérieure annulaire horizontale d'appui 42, ces deux surfaces 42 étend coplanaires avec la face supérieure horizontale 28 de la platine 24.

Chaque plot de fixation 40 comporte un orifice central 44 qui est apte à recevoir, par visage, une tige filetée 48 appartenant ici à une vis de fixation 50.

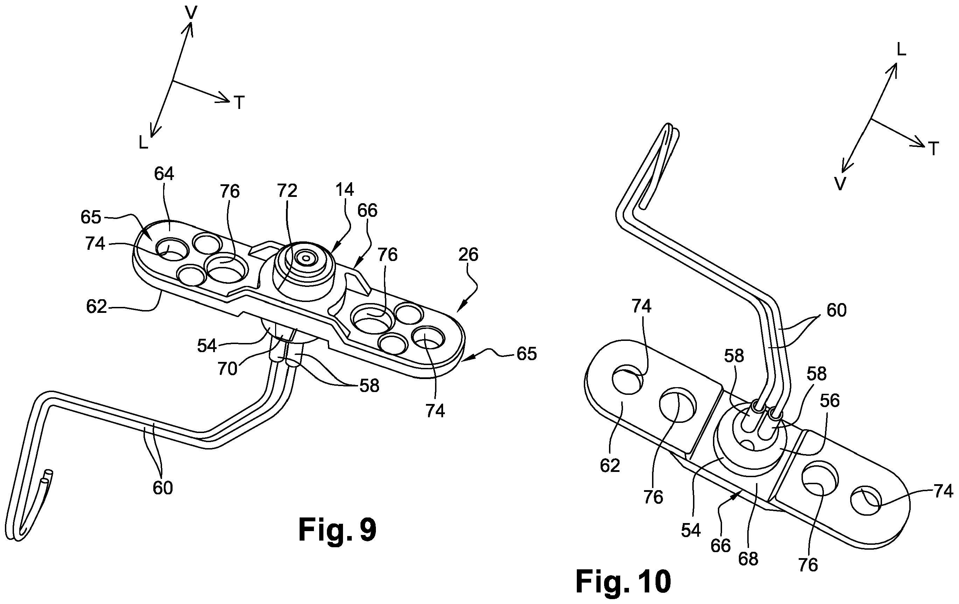

La source lumineuse 14 est ici une source laser, qui est notamment illustrée en détail aux figures 7,9, 10,11 et 13.

La source laser 14 comporte un boîtier 52 qui est ici de forme générale cylindrique à section circulaire et qui comporte une collerette inférieure 54 délimitant un épaulement radial annulaire 56 orienté vers le haut.

Le boîtier 52 est délimité par une face horizontale inférieure plane 56 en forme générale de disque.

La source lumineuse laser 14 comporte deux bornes de raccordement 58 pour son alimentation électrique dont chacune se prolonge par un fil d'alimentation 60.

Chaque borne de raccordement 58 s'étend verticalement vers le bas à partir de la face inférieure 56.

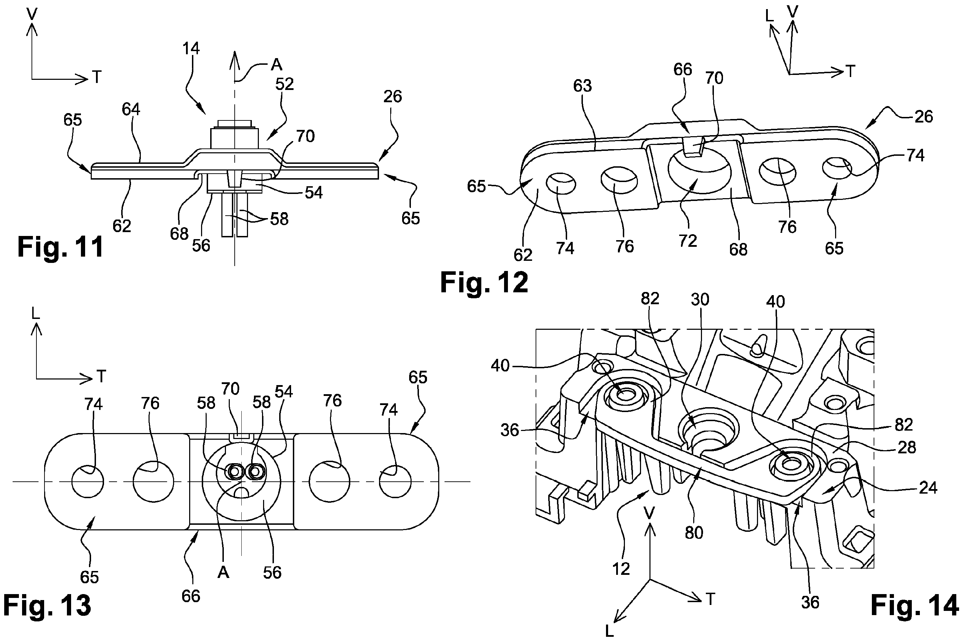

Comme cela est illustré avec précision à la figure 13, les deux bornes de raccordement 58 sont décalées par excentrement radial par rapport à l'axe central général A du boîtier 52 qui correspond sensiblement à l'axe principal d'émission de la source lumineuse 14.

Chacune des bornes de raccordement 58, lorsque la source lumineuse 14 est positionnée par rapport au radiateur 12, est décalée transversalement et longitudinalement vers l'avant par rapport à l'axe A.

Conformément à l'invention, le montage, le positionnement et la fixation du boîtier 52 de la source lumineuse laser 14 sur le radiateur 12 est réalisée par l'intermédiaire de la monture 26 sur laquelle le boîtier 52 de la source laser 14 est monté et fixé, la monture 26 étend elle-même positionnée et fixée sur la face supérieure 28 de la platine 24.

La monture 26 est ici en forme générale d'une plaque d'orientation horizontale et de contour général rectangulaire dont les extrémités sont arrondies.

La monture 26 est délimitée verticalement par une face inférieure horizontale plane 62 et par une face supérieure horizontale plane 64.

Dans sa partie centrale, la monture 26 comporte un corps central 66 formé globalement en surépaisseur par rapport à la face supérieure 64.

Ainsi, la platine 26 se présente sous la forme d'un corps central 66 qui est prolongée par deux ailettes latérales 65 d'orientation transversale dont chacune est en forme de plaque.

Le corps central 66 est délimité verticalement vers le bas par un fond horizontal plat 68 qui est décalé verticalement vers le haut par rapport au plan de la face inférieure 62.

Au voisinage du bord longitudinal avant 63 de la monture 26, le corps central 66 comporte un doigt d'indexation 70 qui s'étend verticalement vers le bas et qui est apte à être reçu dans le passage 34 de la platine 24 du radiateur 12 pour constituer un moyen de détrompage de l'orientation générale de la monture 26 par rapport à la platine 24.

Le corps central 66 comporte un logement central cylindrique 72 de contour circulaire et d'orientation axiale verticale orthogonale au plan de la face supérieure 64.

Le logement central 72 et le logement dans lequel est reçu et monter le corps 52 de la source lumineuse laser 14.

La source lumineuse laser 14, par l'intermédiaire de son boîtier 52, occupe une position fixe déterminée par rapport à la platine 26 selon les trois axes.

À cet effet, le corps 52 peut-être emmanché à force dans le logement central 72 et/ou fixé par collage.

La position verticale du boîtier 52 par rapport à la platine 26 est déterminée ' par la venue en butée axiale vers le haut de l'épaulement radial 56 contre la portion en vis-à-vis du fond 68 du corps central 66.

Lors de l'assemblage et de la solidarisation du boîtier 52 par rapport à la platine 26, le procédé pour son montage consiste aussi à assurer une orientation angulaire déterminer du boîtier 52 autour de son axe par rapport à la platine 26 de manière telle, comme cela est illustré à la figure 13, que les bornes de raccordement 58 soient excentrées et orientées comme décrit précédemment, notamment longitudinalement vers l'avant en regard du doigt d'indexation 70.

Au voisinage de chacune de ses extrémités transversales opposées, la platine 26 comporte un trou cylindrique de fixation traversant 74.

Chaque trou de fixation 74 et apte à traverser axialement par la tige filetée 48 d'une vis de fixations associée 50.

Le diamètre intérieur de chaque trou de fixation 74 est nettement supérieur au diamètre extérieur de la tige filetée 48 de telle manière que cette dernière est reçue avec jeu radial dans le trou associé 74 pour, comme cela sera expliqué par la suite, permettre un réglage, dans le plan horizontal L, T, de la position de la monture 26 par rapport à la platine 24.

La collerette inférieure 54 du boîtier 52 est aussi avec jeu radial dans le logement 30 de la platine 24.

Enfin, chaque aile latérale 65 comporte, entre le trou de fixation 74 et le corps central 66,1 trou cylindrique débouchant 76 qui est un trou de préhension pour permettre la manipulation de la platine 26 par rapport au radiateur 12, par exemple au moyen d'une tête de manipulation (non représentée) motorisée.

De manière optionnelle, et notamment dans le cas de l'utilisation d'une source lumineuse de type laser, le module optique 10 est équipé d'un écran diffuseur 80 qui est illustré en détail à la figure 14.

Pour son montage et sa fixation, l'écran 80 comporte deux pattes transversales opposées 82 dont chacune est reçue dans un logement associé 36 de la platine 24 du radiateur 12, chaque patte 82 étend traversée par un plot associé 40.

Le positionnement précis et la fixation de la source lumineuse 14 et du réflecteur optique 16 sur le radiateur 12 s'effectue de la manière suivante.

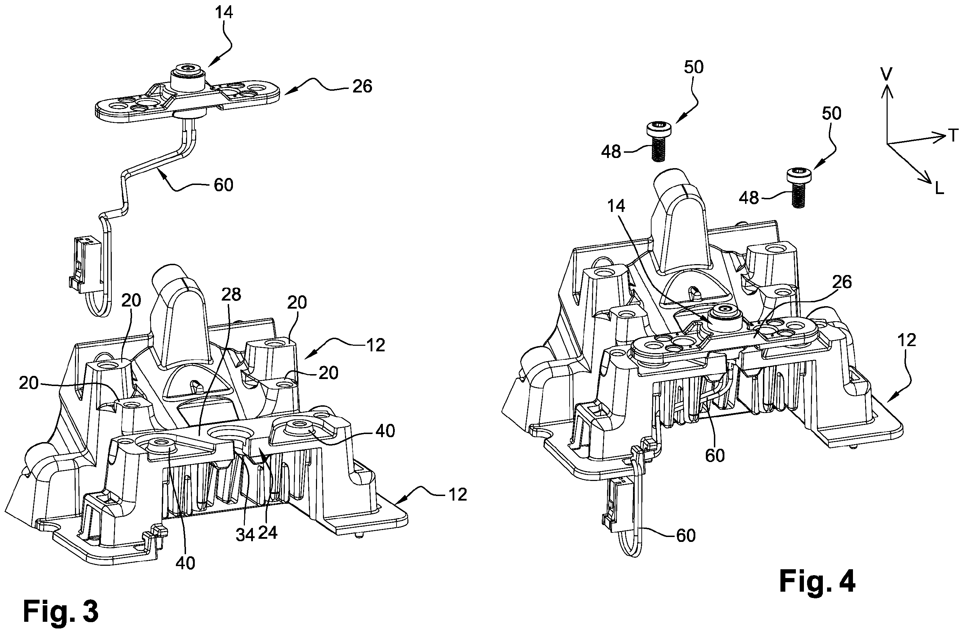

Après avoir assemblé et fixé la source lumineuse 14 et la monture 26, le sous-ensemble est amené par rapport au radiateur 12 dans la position illustrée à la figure 3.

À partir de cette position, la platine 26, avec son doigt d'indexation 70, est amené en position par rapport à la platine 24 avec sa face inférieure 62 en appui plan horizontal sur des portions en vis-à-vis de la face supérieure horizontale 28 de la platine 24.

Lors de cette mise en place, le passage 34 reçoit le doigt d'indexation 70.

À ce stade, il est possible de mettre en place les vis de fixation 50 envies sans partiellement leur tige filetée 48 dans un orifice de fixation 46, sans serrage vertical de la platine 26.

À titre de variante, les vis de fixation 50 peuvent être mises en place et vissées après l'étape de réglage du positionnement de la monture 26 par rapport à la platine 24.

La manipulation de la monture 26, par exemple au moyen d'un robot manipulateur coopérant avec les trous de préhension 76 permet ensuite, comme cela est schématisé à la figure 4, de positionner avec précision, dans le plan horizontal, la monture 26 par rapport à la platine 24 du radiateur 12 afin de positionner avec précision l'axe général d'émission du faisceau lumineux de la source lumineuse laser 14.

Un tel positionnement précis peut être assuré par tous moyens connus, et par exemple par des moyens d'imagerie.

Lorsque la position précise de la monture 26 par rapport à la platine 24, on procède alors au visage complet des vis de fixation 50 pour assurer une immobilisation par serrage vertical de la monture 26 sur la platine 24.

À ce stade illustré à la figure 5, par l'intermédiaire de sa monture 26, la source lumineuse laser 14 et positionner avec toute la précision souhaitée par rapport au radiateur 12.

L'étape suivante consiste alors à positionner et à fixer le réflecteur optique 16 sur le radiateur 12 de manière à positionner et à fixer - de manière précise - le réflecteur optique 16 par rapport à la source lumineuse laser 14.

Ainsi, selon la conception qui vient d'être décrite, la source lumineuse 14 est positionnée directement par rapport à la monture 26 qui fait fonction de surface de référence pour la source lumineuse, et elle est positionnée indirectement par rapport au réflecteur optique 16 qui est lui-même positionné par rapport à la surface de référence constituée par le radiateur 12 qui est la surface de référence commune à la monture 26 et au réflecteur optique 12.

L'invention n'est pas limitée au mode de réalisation qui vient d'être décrit.

De nombreuses variantes sont possibles et envisageables sans sortir du cadre de l'invention.

La monture 26 peut être réalisée par par exemple par moulage en toute matière, en matière plastique ou en métal, notamment en alliage d'aluminium, en Zamac, etc. ; son matériau étant choisi notamment en fonction de contraintes de déformation et de dilatation thermique.

La monture 26 peut comporter une ou plusieurs sources lumineuses dont chacune est positionnée avec précision par rapport à la platine 26.

La source lumineuse 14 peut comporter un boîtier non cylindrique, de tout autre forme, la monture 26 comportant un logement complémentaire de la forme du boîtier de la source lumineuse.

La monture 26 peut aussi être réalisée en une seule pièce avec tout ou partie du boîtier de la source lumineuse.

La monture 26 peut aussi être solidarisée du boîtier de la source lumineuse par surmoulage autour de ce dernier.

## Revendications

1. Module lumineux (10), notamment d'éclairage et/ou de signalisation, pour véhicule automobile comprenant :
- au moins une source lumineuse (14) à semi-conducteur ;
- un composant optique (16) qui est positionné par rapport à la source lumineuse (14) ;
- et une surface de référence (12, 24) sur laquelle sont fixés la au moins une source lumineuse (14) et le composant optique (16),
**caractérisé en ce que** la au moins une source lumineuse (14) est portée par une monture (26) qui est fixée sur la surface de référence (12, 24) .

2. Module lumineux (10) selon la revendication 1, **caractérisé en ce qu'**il comporte des moyens de réglage de la position de la monture (26) par rapport à la surface de référence (12, 24) et des moyens (48, 50) de fixation de la monture (26) en position réglée sur la surface de référence (12, 24) .

3. Module lumineux (10) selon la revendication 1, **caractérisé en ce que** la monture (26) comporte au moins un trou de fixation (74) pour le passage d'un élément (48, 50) de fixation de la monture (26) sur la surface de référence (12).

4. Module lumineux (10) selon la revendication 3, **caractérisé en ce que** l'élément de fixation (48, 50) comporte une tige filetée (48) qui s'étend axialement et avec jeu radial à travers le trou de fixation (74) .

5. Module lumineux (10) selon l'une quelconque des revendications précédentes, **caractérisé en ce que** la source lumineuse (14) comporte un boîtier (52) qui est reçu et positionné dans un logement complémentaire (72) de la monture (26).

6. Module lumineux (10) selon la revendication 5 prise en combinaison avec l'une des revendications 3 ou 4, **caractérisé en ce que** la monture (26) comporte deux trous de fixation (74), et **en ce que** le logement (72) est agencé entre les deux trous de fixation (74).

7. Module lumineux (10) selon la revendication 6, **caractérisé en ce que** la monture (26) comporte un corps central (66) dans lequel est agencé ledit logement (72), et deux ailes latérales opposées (65) dont chacune s'étend à partir de ce corps central (66) et chacune comporte un trou de fixation (74) .

8. Module lumineux (10) selon la revendication 5, **caractérisé en ce que** le boîtier (52) est monté serré, notamment radialement sans jeu, par introduction axiale dans le logement (72) de la monture (26).

9. Module lumineux (10) selon la revendication 8 prise en combinaison avec les revendications 5 et 4, **caractérisé en ce que** le boîtier (52) est monté dans son logement (30) par introduction selon un axe parallèle à l'axe de la tige filetée (48).

10. Module lumineux (10) selon la revendication 1, **caractérisé en ce que** la monture (26) comporte des moyens (76) de préhension par un organe de manipulation permettant de positionner la monture (26) par rapport à la surface de référence (12, 24).

11. Module lumineux (10) selon la revendication 8, **caractérisé en ce que** la source lumineuse (14) comporte des bornes de raccordement (58) qui sont décalées radialement par rapport à un axe central de son boîtier (52), et **en ce que** la monture (26) comporte des moyens (70) de détrompage qui coopèrent avec des moyens complémentaires (34) de la surface de référence (12, 24) pour déterminer une orientation préférentielle de positionnement de la monture (26).

12. Module lumineux (10) selon la revendication 1, **caractérisé en ce que** la source lumineuse (14) est une source laser, et **en ce que** le module lumineux (10) comporte un écran (80) de diffusion qui est interposé verticalement entre la monture (26) et la surface de référence (12, 24).

13. Module lumineux (10) selon la revendication 1, **caractérisé en ce que** la source lumineuse (14) à semi-conducteur appartient à un groupe comportant notamment une source laser, au moins une diode laser, au moins une diode électroluminescente.

14. Module lumineux (10) selon la revendication 1, **caractérisé en ce que** la surface de référence (12, 24) appartient à un radiateur ou un dissipateur thermique.

15. Module lumineux (10) selon la revendication 1, **caractérisé en ce que** la source lumineuse (14) est positionnée directement par rapport à la monture (26) et indirectement par rapport au composant optique (16) qui est positionné par rapport à la surface de référence (12, 24) commune à la monture (26) et au composant optique (12).
